# EUROPÄISCHE PATENTSCHRIFT

(11) **EP 2 515 380 B1**
(45) Veröffentlichungstag und Bekanntmachung des Hinweises auf die Patenterteilung: **25.05.2016**
(21) Anmeldenummer: 11006937.4
(22) Anmeldetag: 25.08.2011
(51) Int. Cl.: H01R 9/22, H01R 13/52, H05K 7/14, H01H 9/04

(54) **Feldgeräte für erhöhte Sicherheit**
Field devices for improved safety
Appareils de terrain pour une meilleure sécurité

(30) Priorität: 19.04.2011 EP 11003276; 11.06.2011 EP 11004814
(43) Veröffentlichungstag der Anmeldung: 24.10.2012
(73) Patentinhaber: Pepperl + Fuchs GmbH, 68307 Mannheim (DE)
(72) Erfinder: Probst, René, 76137 Karlsruhe (DE); Schubart, Andreas, 68623 Lampertheim (DE); Becker, Udo, 47169 Duisburg (DE); Hillebrand, Rainer, 44879 Bochum (DE)
(74) Vertreter: Mierswa, Klaus

(56) Entgegenhaltungen:
- EP-A2- 0 338 259
- WO-A1-2009/118028
- DE-A1- 19 714 868
- DE-A1- 19 901 913

## Beschreibung

Die Erfindung betrifft ein Feldgerät, z.B. ein Feldmodul mit mindestens einem Anschluss für nicht eigensichere Feldgeräte, z.B. Sensoren/Aktoren, und zum Einbau in ein Gehäuse zusammen mit ggf. eigensicheren Sensoren/Aktuatoren.

Außerdem betrifft die Erfindung eine Abdeckung zum Schutz von Kontaktbuchsen eines Steckers, mit in einem Teilungsraster gereihten Kontakstiften und im gleichen Teilungsraster in Reihe angeordneten Kontaktbuchsen zum Einstecken eines Leiters,

Schließlich betrifft die Erfindung ein Verfahren zum Kontaktieren oder Verdrahten von nicht eigensicheren Feldgeräte, vorzugsweise in erhöhter Sicherheit.

Ein Feldbus verbindet in einer Anlage Feldgeräte, sogenannte I/O-Geräte wie Messfühler (Sensoren) und Stellglieder (Aktoren) zwecks Kommunikation mit einem Steuerungsgerät. Der Feldbus ersetzt die parallelen Leitungsbündel durch ein einziges Buskabel und verbindet alle Ebenen, von der Feld- bis zur Leitebene. Unabhängig von der Art des Automatisierungsgeräts, z. B. speicherprogrammierbare Steuerungen (SPS) unterschiedlicher Hersteller oder PC-basierte Steuerungen, vernetzt der Feldbus alle Komponenten. Diese können beliebig im Feld verteilt sein, denn alle werden dezentral vor Ort angeschlossen. Damit steht ein leistungsfähiges Kommunikationsnetz für sogenannte Echtzeit-Rationalisierungskonzepte zur Verfügung. Statt eines Feldbusgerätes kann die Anordnung von Klemme und Abdeckung auch für andere im explosionsgefährdeten Bereich verwendete Geräte zum Einsatz kommen.

Ein Vorteil eines Feldbusses im Vergleich zur parallelen Verdrahtung ist ein geringerer Verkabelungsaufwand, der Zeit bei Planung und Installation der Kabel spart. Es werden Rangierverteiler und Ausmaße von Schaltschränken reduziert.

Bekannt ist ein Modul für eine aus mehreren auf einem Träger nebeneinander angeordneten Modulen bestehende Steuerung, insbesondere zur Aufnahme von analogen Eingängen und/oder Ausgängen mit mindestens einer in einem Gehäuse angeordneten Leiterplatte, wobei in dem Gehäuse mehrere übereinander angeordnete Führungen zur Aufnahme von Schubblöcken vorgesehen sind, wo-bei den Schubblöcken jeweils ein Eingang oder Ausgang zugeordnet ist, und dass die Schubblöcke von der Frontseite her in die Führungen einschiebbar sind (EP 0 338 259 A2).

Ferner ist ein elektrisches Baukastenmodulsystem mit einem variabel einsetzbaren Feldbusmodul bekannt, das eine Schnittstelle zur Verbindung mit einer entfernten Zentralstation besitzt, das mit an das Feldbusmodul anreihbaren E/A-Modulen zur Verbindung mit angebauten und/oder entfernten Aktoren und/oder Sensoren, mit an das Feldbusmodul mechanisch und elektrisch anreihbaren Ventilmodulen einer elektromagnetischen Ventilbatterie, mit einer Modulschnittstelle am Feldbusmodul zur elektrischen Verbindung mit angereihten E/A-Modulen und/oder Ventilmodulen und mit einer Kabelschnittstelle zur Kabelverbindung mit entfernten, durch das Feldbusmodul steuerbaren Modulen oder Modulsystemen (WO 2009/118028 A1).

Des Weiteren ist ein elektrisches Gerät mit einem Gehäuse bekannt, das wenigstens eine mit elektrischen und/oder elektronischen Bauelementen versehene Leiterplatte enthält und elektrische Anschlusseinrichtungen aufweist (DE 199 01 913 A1). Das Gehäuse besteht aus einem Strangprofilelement mit im Wesentlichen U-förmigem Querschnitt, dessen beide einander gegenüberliegenden offenen Seiten durch am Strangprofilelement befestigte Seitenwandungen abgedeckt sind, wobei die elektrischen Anschlusseinrichtungen an der Leiterplatte befestigt sind. Diese Leiterplatte ist im Gehäuse mit wenigstens einer elektrisch isolierenden Vergussmasse so vergossen, dass der Zugang zu den elektrischen Anschlusseinrichtungen frei bleibt.

Schließlich ist eine busfähige elektrische Koppeleinheit mit einem Gehäuse, mindestens einem Busanschluss, einem Schnittstellenanschluss für eine mehrfache elektrische Schnittstelle für mehrere anzusteuernde und/oder ansteuernde elektrische Einrichtungen, insbesondere Schaltgeräte, und einer zwischen Busanschluss und Schnittstellenanschluss angeordneten elektronischen Baugruppe zur Organisation des Datenaustausches zwischen dem Bus und den elektrischen Einrichtungen, wobei unterschiedliche, austauschbare Verarbeitungsmodule vorgesehen sind, die in das Gehäuse unter Herstellung der elektrischen Verbindungen zu dem mindestens einen Busanschluss und dem Schnittstellenartschluss einsetzbar sind und die elektronische Baugruppe enthalten, die mit dem jeweiligen Bussystem kompatibel ist (DE 197 14 868 A1).

In explosionsgefährdeten Bereichen werden für Aufgaben der Mess- und Regeltechnik elektrische bzw. elektronische Geräte in der Zündschutzart eigensicher (bis 12/2004 mit EExi abgekürzt, seither nur Exi, englisch: intrinsic safety) eingesetzt. In diesen Geräten kann durch eine Begrenzung von Strom und Spannung keine zündfähige Energie auftreten. Das bedeutet, dass eine mögliche Funkenbildung keine Explosion von explosionsfähigen Brennstoff-Luftgemischen auslösen kann.
Für die verschiedenen Arten, wie Zündquellen verhindert werden können, sind verschiedene Zündschutzarten definiert worden, die in verschiedenen internationalen und europäischen Normen beschrieben sind. Innerhalb der Richtlinien der Europäischen Gemeinschaft werden diese ebenfalls beschrieben.

Als Zündschutzarten stehen zur Verfügung für elektrische Betriebsmittel in Gas u.a. Eigensicherheit Ex i, Druckfeste Kapselung Ex d, Erhöhte Sicherheit Ex e, Überdruckkapselung Ex p nach DIN VDE 0165.

Explosionsgefährdete Bereiche werden nach Häufigkeit und Dauer des Auftretens von gefährlicher explosionsgefährdeter Atmosphäre in Zonen unterteilt.

FB (Feldbus) Remote I/O Stationen, d.h. Feldmodule werden in Zone 1 oder Zone 21 montiert. Sie bilden ein modulares System zur Signalanpassung zwischen Feldgeräten im explosionsgefährdeten und Steuerungen oder Leitsystemen im sicheren Bereich. FB Remote I/O-stationen verbinden konventionelle Sensorik und Aktorik über eine einzige Feldbusleitung mit einem Prozessleitsystem und verwenden dazu einen genormten Bus (Profibus, Modbus und andere). Die Erfindung ist jedoch nicht auf Anwendungen mit Remote I/O, dem Feldmodul, beschränkt. Sie betrifft auch die im Feld angeordneten Geräte selbst, die auch als Feldgeräte bezeichnet werden. Der Begriff "Feldgerät" wird im Folgenden je nach Zusammenhang für das Feldgerät selbst als auch als Oberbegriff von Feldmodul und Feldgerät gebraucht, da beide über Leiter miteinander verbunden werden und die Erfindung deren Kontaktierung beziehungsweise Verdrahtung betrifft.

Die verschiedenen Remote I/O E/A-Module, d.h. Feldmodule sind meist als Steckeinheit steckbar in Kästen angeordnet; Montage bzw. Entnahme sind unter Spannung, nur mit Feuererlaubnisschein, möglich.

Ein breites Spektrum an ein- und vielkanaligen E/A Modulen, insbesondere als Steckeinheiten, mit Exi und Exe Feldanschlüssen ermöglichen eine einfache und durchgängige Anlagenkonzeption.

Erhöhte Sicherheit Exe dient zum Anschluss, insbesondere folgender Geräte:
Typische im Feld angeschlossene Geräte sind Relais, Module zum Schalten von Leistungskreisen, Analogausgänge von gekapselten Feldgeräten, die keine eigensicheren Stromkreise anbieten, Analogeingänge von druckfest gekapselten motorgetriebenen Ventilen, Binärausgänge von nichteigensicheren Sensoren, Binäreingänge zu nicht-eigensicheren Stromkreisen z.B. Magnetventilen.

Die Remote I/O E/A Module, d.h. Steckeinheiten, besitzen Kabelschwänze die an gesondert zugelassenen Klemmen in erhöhter Sicherheit angeschlossen werden. Diese mussten mit einer IP 30 Abdeckung versehen sein, um ein versehentliches Berühren von leitfähigen Teilen zu verhindern.

Damit sind aber die Probleme, die sich in Schaltschränken und -gehäusen ergeben nicht gelöst, denn Module mit Kabelschwänzen oder Drahtenden existieren in vielen unterschiedlichen Varianten, um die verschiedenen Kabellängen abzudecken, die für die Verwendung in Schränken und Gehäusen notwendig sind. Es sind gesonderte, separat zu montierende Klemmen in Ex-e Ausführung notwendig, um die Feldleitungen anzuschließen, was zusätzlich Platz erfordert und Kosten verursacht, da auch ungenutzte Leitungen vorverdrahtet werden müssen.

Es besteht somit ein dringendes Bedürfnis, die Verdrahtung von nicht eigensicheren Feldgeräten zu vereinfachen, eine höhere Packungsdichte der Module zu erreichen und die Variantenvielfalt an Modulen mit Kabelschwänzen zu verringern.

[A1] Bei einem Feldgerät nach Anspruch 1, insbesondere einem Feldmodul mit mindestens einem Anschluss für nicht eigensicherer Sensoren/Aktoren und zum Einbau in einem Gehäuse wird diese Aufgabe dadurch gelöst, dass das Feldgerät zum Anschluß Kontaktbuchsen aufweist, die vorzugsweise als selbsthaltende federkraftbelastete und entriegelbare Klemmkontakte oder als Exe zugelassene Schraubklemmen ausgebildet sind, wobei nicht benutzte Kontaktbuchsen oder Schraubklemmen von einer Abdeckung geschützt ausgebildet sind.

Durch Kontaktbuchsen, in die die Leiter von Feldgeräten eingesteckt werden und mit sich selbsttätigender Verriegelung können die Feldgeräte direkt an das Feldmodul angeschlossen werden, ohne zusätzliche Ex-e Klemmblöcke verwenden zu müssen. Die Packungsdichte der Module ist folglich im Schaltgehäuse erhöht. Auch ist der Abstand zu einem etwaig benachbarten eigensicheren Feldmodul mittels eines Freilassens eines Steckplatzes vernachlässigbar. Vorgeschriebene Abstände von einer Fadenlänge von mindestens 50mm nach IEC/EN 60079-11 sind sicherstellbar.

Nicht benötigte Kontakte bleiben von der Abdeckung verschlossen, so dass eine Vorverdrahtung nicht benötigter Kabelschwänze entfällt. S Die Kontaktbuchse ist eine selbst straffende Käfigklemme, die den Draht eines Leiters umso fester hält, je fester man an ihm zieht. Der Kontakt muss nicht nur die Feldverdrahtung halten, ohne einen Funken durch eine sich lösende Verbindungen zu verursachen, sondern der Federkontakt muss auch den Draht im Falle von Vibrationen sicher verankern. Es konnte überraschender Weise nachgewiesen werden, dass die elektrische Verbindung hin zur Kontaktbuchse auch von einem der beiden Kontakte aufrechterhalten wird, wenn der andere Kontakt abbricht. Intensive Tests zeigten, dass der verbleibende Kontakt bei einem maximal zugelassenen Bemessungsstrom nicht überhitzt und die erforderlichen Luft- und Kriechstrecken zwischen benachbarten Stromkreisen den Anforderungen der Norm für die erhöhte Sicherheit genügen. Ein Rastermaß des Kontaktabstandes von 3,81 mm reicht dazu bei 1 A Bemessungsstrom beispielsweise aus. Damit sind die Anforderungen der erhöhten Sicherheit an den Steckverbinder erfüllt.

Ausserdem besteht erfindungsgemäß nunmehr die Möglichkeit, das Gehäuse zu öffnen, in dem sich die Module mit eigensicheren und nichteigensicheren Stromkreisen befinden, ohne eine Heißarbeitserlaubnis beantragen zu müssen, da die Stromkreise in erhöhter Sicherheit durch die Abdeckung nicht zugänglich sind.
[A2] In Ausgestaltung der Erfindung sind Kontaktbuchsen in einem Stecker mit Kontaktstiften angeordnet und dem Stecker ist die Abdeckung zugeordnet, wobei eine Achsrichtung der Kontaktbuchsen und der Kontaktstifte parallel und entgegengesetzt ausgebildet ist.
   Dies ermöglicht nicht nur eine schnelle Verdrahtung und einen schnellen Austausch von Feldgeräten sondern auch einen schnellen Austausch bestehender Feldmodule mit Kabelschwänzen. Beim Austausch einer Feldmodul mit Drahtenden in einer bestehenden Anlage ist dieses auf Grund des Steckkontaktes zügig und einfach durchführbar.
   Dazu ist entweder der frontseitige Stromkreis stromlos schaltbar oder eine Person mit Heißarbeitserlaubnis notwendig. Danach werden die Drähte dicht am Feldmodul bzw. am Feldgerät abgeschnitten und ggf. die abisolierten Drahtenden mit Aderendhülsen versehen. Die zu tauschende Modul ist dann aus der Montageplatte, sogenannte Backplane ausziehbar und durch eine neue Modul mit steckbaren Frontanschlüssen ersetzbar. Dazu wird die erfindungsgemäße Abdeckung an den Stellen, in die ein Draht eingeführt wird, durch Abbrechen einer zugehörigen Lasche entfernt. Anschließend werden die benötigten Drähte in die Kontaktbuchse eingeführt. Zum Entriegeln der Kontaktbuchse ist geeignetes Werkzeug zu verwenden. Abschließend wird die Abdeckung mittels zweier Schrauben den Stecker abdeckend am Modul befestigt, sodass dann der Austausch abgeschlossen ist.
[A3] Dazu ist in weiterer Ausgestaltung der Erfindung vorgesehen, dass die Kontaktstifte des Steckers in Buchsen eingesteckt sind, die vorzugsweise im Feldgerät eingegossen sind.
   Diese Buchsen unterscheiden sich von den Kontaktbuchsen dadurch, das sie nicht selbstverriegelnd ausgebildet sind. Der Stecker weist stattdessen selbstverriegelnde Kontaktbuchsen auf, in die dann die Leiter eines nicht eigensicheren Feldgerätes eingesteckt werden.
[A4] Die Maßnahme, dass die Abdeckung an dem Feldgerät befestigt ist, vorzugsweise mittels Schrauben, verhindert dass der Stecker unbeabsichtigt gelöst werden kann. Dadurch ist eine Abdeckung für den Steckkontakt geschaffen, die sowohl die Kabelschwänze als auch separat montierte, zusätzlichen Ex e Klemmen überflüssig macht. Die Kontaktbuchsen ersetzen die Kabelschwänze und Drahtenden. Die Abdeckung erfüllt gleich mehrere Funktionen: Sie sichert den Stecker gegen unbeabsichtigtes Lösen; sie deckt blanke leitfähige Teile ab; sie deckt die orangefarbenen Entriegelungen ab, so dass unter Spannung stehende Drähte nicht entfernt werden können; sie verhindert das Drähte mit einem Durchmesser >1mm ungewollt eindringen können; sie gewährleistet den erforderlichen Trennabstand zu eigensicheren Stromkreisen; sie erlaubt es dem Kunden das Gehäuse, in dem sich die Module befinden, zu öffnen ohne vorherige Spannungsabschaltung und ohne Heißarbeitserlaubnis. Statt der steckbaren Exe Klemmen können auch fest am Gerät montierte Klemmen zum Einsatz kommen. Diese können statt mit Federzugklemmen auch mit Exe zugelassenen Schraubklemmen ausgestattet sein.
   In der Reihenfolge in der die Feldleitungen in die Kontaktbuchsen gesteckt werden sollen, werden die Laschen der Abdeckung an den entsprechenden Positionen abgebrochen. Die ungenutzten Öffnungen bleiben weiterhin durch die zugehörigen Laschen der Abdeckung überdeckt, so dass keine blanken leitfähigen Teile offen liegen.
[A5] Die Maßnahme, dass Kontaktbuchsen von individuellen Laschen der Abdeckung geschützt ausgebildet sind, vermeidet die Handhabung einer gemeinsamen Abdeckung wie sie bei getrennt montierten Exe Klemmen bisher üblich war. Dadurch ist ein schnelleres Verdrahten und -schalten der Module und der Feldgeräte möglich. Steckerabdeckungen für gemeinsame 6 bis 8 Kontakte mit Einzellaschen werden als besonders vorteilhaft angesehen. Es sind aber auch grössere Einheiten denkbar.
[A6] Die Kontaktstifte des Steckers sind in einem Teilungsraster angeordnet und die Abdeckung weist einseitig eingebrachte Schlitze im Abstand des Teilungsrasters auf, so dass Abdeckfahnen geformt sind und das Anpassen der Abdeckung an die Anschlussbelegung durch einfaches Abbrechen von Laschen erfolgen kann. Falls zu einem späteren Zeitpunkt die Verdrahtung am Stecker geändert werden soll, muss sichergestellt sein, dass keine leitfähigen Teile ungeschützt bleiben. Wenn z.B. ein Draht an einer Stelle entfernt wird, an der vorher die Lasche der Abdeckung abgebrochen wurde, darf die Öffnung jetzt nicht frei bleiben. In diesem Fall muss die Abdeckung durch eine neue Abdeckung ersetzt werden und die Laschen nur dort abgebrochen werden, wo Drähte in die jeweiligen Steckeröffnungen eingeführt werden sollen.
[A7] Zum Entfemen der Laschen ist es vorteilhaft, dass in weiterer Ausgestaltung jede Abdeckfahne eine Sollbruchstelle aufweist. Dadurch wird zum Entfernen der Lasche kein besonderes Werkzeug benötigt. Die Laschen können mit einem Schraubenzieher angehoben und abgebrochen werden.
[A8] Auch die Maßnahme, dass jeder Kontaktbuchse eine Leiterentriegelung zugeordnet ist, die auch bei einem in die Kontaktbuchse eingeführten Leiter von der Abdeckung abgedeckt angeordnet ist, wird ein unbeabsichtigtes Lösen des Leiters verhindert.
[A9] Die Aufgabe wird auch durch eine Abdeckung zum Schutz von Kontaktbuchsen eines Steckers mit in einem Teilungsraster gereihten Kontaktstift und im Teilungsraster in Reihe angeordneten Kontaktbuchsen zum Einstecken eines Leiters dadurch gelöst, dass bei die Abdeckung zum Aufstecken auf den Stecker in Steckrichtung mindestens eine Führung aufweist und quer dazu eine die Kontaktbuchsen abdeckende Schutzfläche aufweist. Eine erhebliche Platzersparnis ist der entscheidende Vorteil, der durch die erfindungsgemäße Abdeckung erreicht wird. Das Positionieren der Abdeckung auf dem in ein Feldgerät gesteckten Stecker und ihre feste Verbindung mit dem Feldgerät wird dadurch sehr erleichtert.
[A10] Weil die Schutzfläche im Raster der Kontaktbuchsen quer zur Kante der Schutzfläche Schlitze aufweist, so dass einzeln schützende Abdeckfahnen gebildet sind, ergeben sich Laschen, die einzeln genau einem Kontakt zugeordnet sind und diesen abdecken. Eine einzelne Kontaktbuchse des Steckers wird also von genau einer Fahne abgedeckt, die dann alleine zum Freilegen der Einführöffnung entfernt werden kann. Die Abdeckung ist folglich individuell anpassbar.
[A11] Die Abdeckung ist wie eine Schachtel aufgebaut, der zwei Flächen fehlen. Dadurch ergibt sich, dass die Führung als eine den Stecker an drei Seiten mindestens teilweise umhüllende Wand ausgebildet ist und die Schutzfläche vorzugsweise nur teilweise in die von den Führungsflächen freigelassene Fläche hineinreicht.
[A12] Zusammen mit der Ausgestaltung, dass die Schlitze zur freien Fläche hin geöffnet sind und nur soweit in die Schutzfläche hineinreichen, dass die Entriegelungsmechanismen der Leiterentriegelung des Steckers bedeckt bleiben, kann auch im montierten Zustand unter das Ende einer Schutzfahne gefasst werden und diese durch Abbrechen entfernt werden. Ein unbeabsichtigtes Freilegen des Entriegelungsmechanismus wird jedoch verhindert.
[A13, A14] Dabei wird das Unterfassen des Fahnenendes und das Entfernen der Fahne dadurch erleichtert, die Schutzfahnen an ihren Enden von dem Stecker beabstandet ausgebildet sind und dass die Schutzfahnen Sollbruchstellen aufweisen.
[A15] Mit Vorteil bleibt der Stecker und die Abdeckung während des Betriebs fest mit dem Feldgerät verbunden, weil die Kontaktabdeckung Befestigungselemente, zur Befestigung am Feldgerät aufweist. So ist es möglich das Gehäuse in dem sich das Feldgerät befindet unter Ex-Bedingungen ohne Heissarbeitserlaubnis oder vorheriges Abschalten der Anlage zu öffnen.

Schließlich wird die Verfahrensaufgabe durch ein Verfahren zum Kontaktieren oder Verdrahten von nicht eigensicheren Feldgeräten, vorzugsweise in erhöhter Sicherheit gelöst, bei dem ein Stecker mit Kontaktstiften und Kontaktbuchsen, vorzugsweise mit selbstverriegelnden Federkontaktbuchsen, in Feldgeräte mit Kontaktbuchsen eingesteckt wird und von einer Abdeckung nach Art einer Haube abgedeckt wird und die Abdeckung an dem Feldgerät befestigt wird, sowie die Leiter der Feldgeräte nach Entfernen der zugehörigen Schutzfahnen in die Kontaktbuchsen des Steckers eingesteckt werden und dabei im Stecker verriegelt werden. Starre Leiter, müssen bevor sie in die Steckeröffnungen gesteckt werden an Ihren Enden vorschriftsmäßig abisoliert werden. Flexible Leitungen müssen mit einer Aderendhülse versehen werden, um den erforderlichen Abstand zwischen benachbarten Kreisen sicherzustellen und um die Leitungen sicher in den Kontakt einführen zu können.

Eine bevorzugte Ausführungsform der Erfindung wird beispielhaft an Hand einer Zeichnung erläutert.

Die Figuren der Zeichnung zeigen im Einzelnen:
- Figur 1: schematisch eine Aufsicht auf ein geöffnetes Gehäuse mit eigensicheren und nicht eigensicheren Feldgeräten,
- Figur 2: eine schematische Aufsicht auf zwei der in Figur 1 dargestellten Feldmodule,
- Figur 3: eine perspektivische Ansicht einer erfindungsgemäßen Abdeckung,
- Figur 4: eine perspektivische Ansicht der erfindungsgemäßen Abdeckung,
- Figur 5: den zur Abdeckung gemäß Figur 4 zugehörigen Stecker in perspektivischer Ansicht und
- Figur 6: in perspektivischer Ansicht den Stecker und die Abdeckung als zusammengefügte Baugruppe.

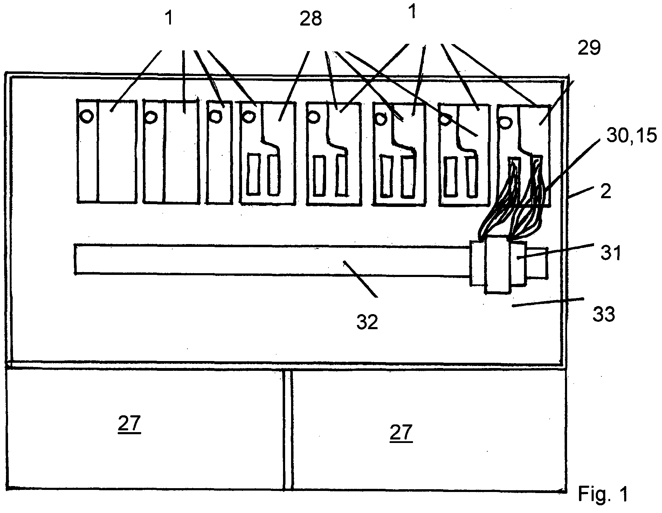

Figur 1 stellt den derzeitigen Stand der Technik dar, bei dem unterschiedliche Feldmodule 1 in einem Gehäuse 2 auf einer gemeinsamen Rückplatte, auch backplane genannt, montiert sind.

Es sind sowohl Feldmodule in erhöhter Sicherheit 29 und eigensichere Feldmodule 28 gemeinsam im Gehäuse 2 verbaut. Diese Feldmodule 29 besitzen Kabelschwänze, z. B. 16 Stück, die im Feldmodul 29 vergossen sind und deren freie Enden auf einen Ex-e Klemmenblock 31 geführt sind. Um die verschiedenen Kabellängen abzudecken, die für die Verwendung in Schränken und Gehäusen notwendig sind, gibt es eine Vielzahl unterschiedlicher Varianten derselben Feldmoduls 29 für nicht eigensichere I/Os. Zur Montage des Ex-e Klemmenblocks muss zusätzlich auf der Rückseite des Gehäuses 2 eine Hutschiene 32 vorgesehen werden. Der Übersichtlichkeit wegen sind keine weiteren üblichen Einbauten dargestellt. Die Anschlusseinheit 27 schließt sich unterhalb der Monatgeplatte 33 an. Kabelschwänze 30 verbinden Feldmodule 28, 29 mit einem Ex-e Klemmblock.

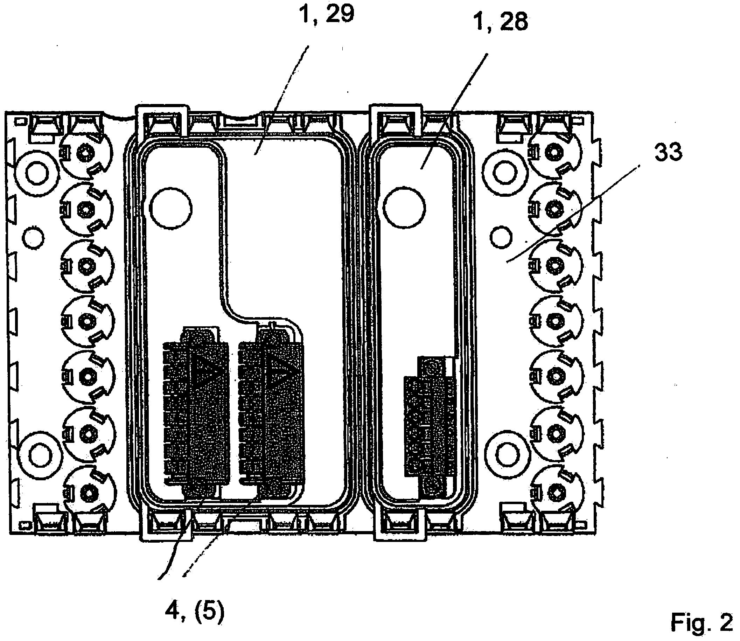

Fig. 2 zeigt die rückseitige Montageplatte 33 auf der ein eigensicheres Feldmodul und ein Feldmodul in erhöhter Sicherheit dargestellt sind. Erfindungsgemäß weist das Feldmodul in erhöhter Sicherheit keine Kabelschwänze auf. Stattdessen sind in Figur 2 zwei erfindungsgemäße Abdeckungen 4 erkennbar, die in dieser Darstellung nicht sichtbare Stecker (5) verdecken und auf die Frontseite des nicht eigensicheren Feldmoduls 29 aufgeschraubt sind.

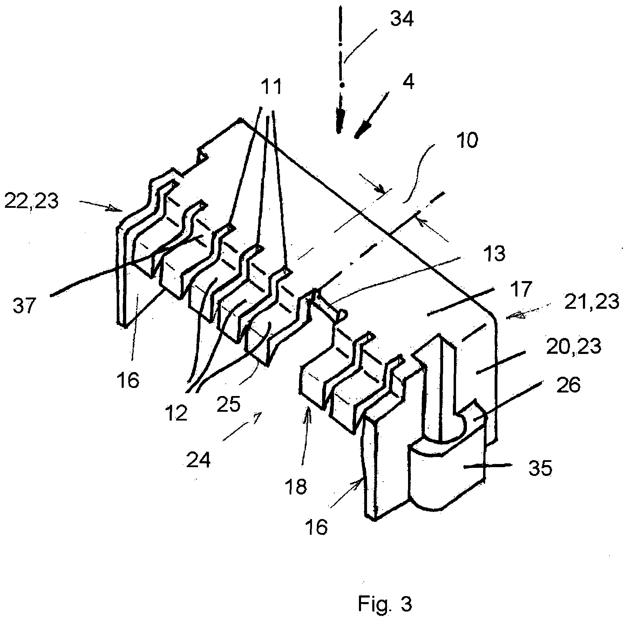

In Figur 3 ist die in Figur 2 gezeigte Abdeckung 4 in vergrößerter perspektivischer Darstellung gezeigt. Die Abdeckung 4 ist einstückig als Spritzgussteil aus Kunststoff hergestellt. Sie wird von oben auf den nicht dargestellten Stecker gesteckt. Beim Aufstecken in Steckrichtung 34 wird dabei die Abdeckung 4 von den Innenflächen 23 der Seiten 20, 21, 22 geführt bis die Schutzfläche 17 auf dem Stecker anliegt und die Kontaktbuchsen 3 des Steckers 5 abdeckt. Zur Befestigung der Abdeckung 4 auf einem Feldmodul 1, 29 weisen die Wände an Seite 22 und 20 als Befestigungselemente 26 Laschen 35 auf. Durch deren Befestigungsöffnungen 36 eine Schraube in ein im Feldmodul vorgesehenes Gewinde greift und so die Abdeckung fest mit dem Feldmodul 29 verbindet. Die von der, den Stecker umhüllenden Wänden 23 frei gelassene Fläche 24 wird von teilweise in die Fläche 24 hineinragende Abdeckfahnen 12 und deren Enden 25 begrenzt. Diese Abdeckfahnen 12 werden seitlich von Schlitzen 11 begrenzt, die von der Fläche 24 in die Schutzfläche 17 in Teilungsraster 10 eingebracht sind.

Die Enden der Abdeckfahnen 12 sind keilförmig ausgebildet, so dass ein sich verjüngender Spalt zu einem von der Abdeckung gehaltenen Stecker ergibt. Die Abdeckfahnen enden an der Kante 18. In diesem Spalt kann hineingegriffen werden und die Abdeckfahne 12 nach oben gezogen werden, bis sie an der vorgesehenen Sollbruchstelle 13 abbricht. Die Sollbruchstelle ist so gelegt, dass nach Entfernen der Abdeckfahne 12 zwar die zugehörige Kontaktbuchse 3 freiliegt, aber die zugehörige Leiterentriegelung 14 noch verdeckt ist. Die Schlitze 11 sind vom freien Ende der Schutzfläche 17 bis etwa zur Lage der Sollbruchstelle 13 in der Abdeckfläche 17 vorgesehen. In der Abdeckfläche 17 ist zusätzlich eine Stufe 37 eingeformt und, so dass die innere Kontur an den zugehörigen Stecker angepasst ist. Die Leiterentriegelungen 14 des Steckers 5 sind nämlich gegenüber den Kontaktbuchsen 3 des Steckers 5 behandelt. Die Führungen 16 liegen seitlich an den Wänden 22.

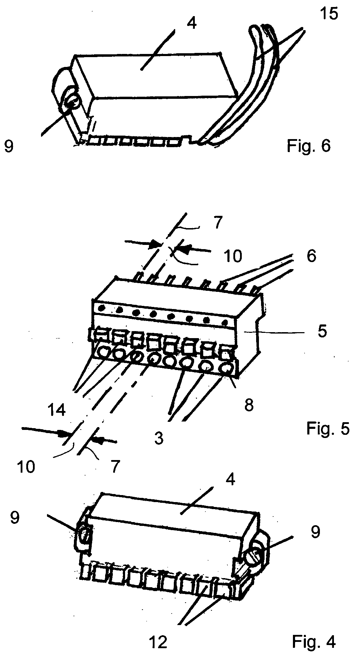

In den Figuren 4 bis 6 sind die Abdeckung, der Stecker und die Baueinheit Stecker mit Abdecker und Leiter einzeln dargestellt. Die untere Abbildung Figur 4 betrifft die Abdeckung, die mittlere Figur 5 den Stecker und die obere Figur 6 die montierte Einheit.

Der in der Mitte dargestellte Stecker hat eine breite Anordnung von Kontaktbuchsen, die in einem Teilungsraster 10 angeordnet sind. Zu jeder Kontaktbuchse gehört zusätzlich eine Leiterentriegelung 14. Soll ein in die Kontaktbuchse 3 eingesteckter Leiter entfernt werden, so ist zunächst diese Leiterentriegelung 14 zu indizieren, um den Leiter 3 entfernen zu können. Sowohl die Buchsen 3 als auch die an der gegenüberliegenden Seite angeordneten Kontaktstifte 6 weisen eine parallele Achsrichtungen 7 auf und sind in einem Teilungsraster 10 jeweils gereiht angeordnet. Zum Anschließen eines Stromkreises in erhöhter Sicherheit werden an den zugehörigen Stellen der Buchse 3 zunächst die Abdeckfahnen 12 entfernt. Nach Einstecken der entsprechenden Leiter 15 in die Kontaktbuchsen 3 wird die Abdeckung 4 über den Stecker 5 gestülpt und mittels der Schrauben 9 in die im Feldmodul vorgesehenen Gewinde eingeschraubt, so dass alle Teile fest mit dem Feldmodul verbunden sind. Die Buchsen 8 liegen in Richtung der Achsrichtung 7.

Die Erfindung kann auch für fest installierte Feldgeräte verwendet werden und beschränkt sich nicht auf steckbare Klemmen mit Federzuganschluss.

### Bezugsziffernliste

- 1: Feldgerät, z.B. Feldmodul
- 2: Gehäuse
- 3: Kontaktbuchsen
- 4: Abdeckung
- 5: Stecker
- 6: Kontaktstift
- 7: Achsrichtung
- 8: Buchsen
- 9: Schrauben
- 10: Teilungsraster
- 11: Schlitz
- 12: Abdeckfahne
- 13: Sollbruchstelle
- 14: Leiterentriegelung
- 15: Leiter
- 16: Führung
- 17: Schutzfläche
- 18: Kante
- 19: -
- 20: Seite
- 21: Seite
- 22: Seite
- 23: Wand
- 24: Fläche
- 25: Ende
- 26: Befestigungselement
- 27: Anschlusseinheit
- 28: eigensicheres Feldmodul
- 29: Feldmodule in erhöhter Sicherheit
- 30: Kabelschwanz
- 31: Ex-e Klemmenblock
- 32: Hutschiene
- 33: Montageplatte
- 34: Steckrichtung
- 35: Laschen
- 36: Befestigungsöffnung
- 37: Stufe

## Patentansprüche

1. Feldgerät mit mindestens einem Anschluss für nicht eigensichere Feldgeräte, z.B. Sensoren/Aktoren, und zum Einbau in ein Gehäuse (2), wobei das Feldgerät zum Anschluss Kontaktbuchsen (3) aufweist, die als selbsthaltende federkraftbelastete und entriegelbare Klemmkontakte oder als Ex-e zugelassene Schraubklemmen ausgebildet sind, wobei nicht benutzte Kontaktbuchsen (3) oder Schraubklemmen von einer Abdeckung (4) geschützt ausgebildet sind und wobei jeder Kontaktbuchse eine Leiterentriegelung (14) zugeordnet ist, die auch bei einem in die Kontaktbuchse (3) eingeführten Leiter (15) von der Abdeckung (4) abgedeckt angeordnet ist **dadurch gekennzeichnet, dass** die Kontaktbuchsen (3) in einem Stecker (5) mit Kontaktstiften (6) angeordnet sind und dem Stecker (5) die Abdeckung (4) zugeordnet ist, wobei eine Achsrichtung (7) der Kontaktbuchsen (3) und der Kontaktstifte (6) parallel und entgegengesetzt ausgebildet ist und wobei die Kontaktstifte des Steckers (5) in einem Teilungsraster (10) angeordnet sind und die Abdeckung (4) einseitig eingebrachte Schlitze (11) im Abstand des Teilungsrasters (10) aufweist, so dass Abdeckfahnen (12) geformt sind.

2. Feldgerät nach Anspruch 1, **dadurch gekennzeichnet, dass** die Kontaktstifte (6) des Steckers (5) in Buchsen (8) eingesteckt sind, die im Feldgerät (1) eingegossen sind.

3. Feldgerät nach Anspruch 1 oder 2, **dadurch gekennzeichnet, dass** die Abdeckung (4) mittels Schrauben (9) an dem Feldgerät (1) befestigt ist.

4. Feldgerät nach einem oder mehreren der vorhergehenden Ansprüche, **dadurch gekennzeichnet, dass** mehrere Kontaktbuchsen (3) von einer gemeinsamen Abdeckung (4) geschützt ausgebildet sind.

5. Feldgerät nach einem oder mehreren der vorhergehenden Ansprüche, **dadurch gekennzeichnet, dass** jede Abdeckfahne (12) eine Sollbruchstelle (13) aufweist.

6. Abdeckung (4) für ein Feldgerät nach den Patentansprüchen 1 bis 5 wobei die Abdeckung (4) zum Aufstecken auf den Stecker (5) in Steckrichtung mindestens eine Führung (16) aufweist und quer dazu eine die Kontaktbuchsen (3) abdeckende Schutzfläche (17) aufweist, wobei jeder Kontaktbuchse (3) eine Leiterentriegelung (14) zugeordnet ist, die auch bei einem in die Kontaktbuchse (3) eingeführten Leiter (15) von der Abdeckung (4) abgedeckt angeordnet ist, **dadurch gekennzeichnet, dass** die Schutzfläche (17) im Teilungsraster (10) der Kontaktbuchsen (3) quer zur Kante (18) der Schutzfläche (17) Schlitze (11) aufweist, so dass einzeln schützende Abdeckfahnen gebildet sind.

7. Abdeckung nach Anspruch 6, **dadurch gekennzeichnet, dass** die Führung (16) als eine den Stecker (5) an drei Seiten (20,21,22) mindestens teilweise umhüllende Wand (23) ausgebildet ist und die Schutzfläche (17) nur teilweise in die freigelassene Fläche (24) hineinreicht.

8. Abdeckung nach Anspruch 6 oder 7, **dadurch gekennzeichnet, dass** die Schlitze (11) zur freigelassenen Fläche (24) hin geöffnet sind und nur soweit in die Schutzfläche (17) hineinreichen, dass die Leiterentriegelungen (14) des Steckers (5) bedeckt bleiben.

9. Abdeckung nach einem der Ansprüche 6 bis 8, **dadurch gekennzeichnet, dass** die Abdeckfahnen (12) an ihren Enden (25) von dem Stecker (5) beabstandet ausgebildet sind.

10. Abdeckung nach einem der Ansprüche 6 bis 9, **dadurch gekennzeichnet, dass** die Abdeckfahnen (12) Sollbruchstellen (13) aufweisen.

11. Abdeckung nach einem der Ansprüche 6 bis 10, **dadurch gekennzeichnet, dass** die Abdeckung (12) Befestigungselemente (26) aufweist, zur Befestigung an einem Feldgerät (1).

12. Verfahren zum Kontaktieren oder Verdrahten von nicht eigensicheren Feldgeräten nach einem der Ansprüche 1 bis 5, in erhöhter Sicherheit, wobei ein Stecker (5) mit Kontaktstiften (6) und Kontaktbuchsen (3) in das Feldgerät mit Buchsen (8) eingesteckt wird und der Stecker von einer Abdeckung (4) nach Art einer Haube abgedeckt wird und die Abdeckung (4) an dem Feldgerät (1) befestigt wird, wobei eine Schutzfläche (17) im Teilungsraster (10) der Kontaktbuchsen (3) quer zur Kante (18) der Schutzfläche (17) Schlitze (11) aufweist, so dass einzeln schützende Abdeckfahnen (12) gebildet sind, sowie die Leiter (15) der Feldgeräte nach Entfernen von zugehörigen abdeckenden Abdeckfahnen (12) in die Kontaktbuchsen (3) des Steckers (5) eingesteckt werden und dabei im Stecker (5) selbsttätig verriegelt werden oder statt steckbarer Anschlüsse fest mit dem Feldgerät verbundene Klemmenblöcke zum Einsatz kommen, wobei eine jede Kontaktbuchse (3) zugeordnete Leierentriegelung (14) auch beim Einführen eines Leiters (15) in die Kontaktbuchse (3) von der Abdeckung (4) abgedeckt bleibt.

## Claims

1. Field device with at least one terminal for non-intrinsically safe field devices, for example sensors/actuators, and for installation into a housing (2) wherein, for the purpose of connecting, the field device comprises [female] socket contacts (3) implemented as self-retaining, spring-loaded and unlatchable clamp contacts or as Ex-e approved screw-type contacts, wherein non-utilized socket contacts (3) or screw-type contacts are implemented such that they are protected by a cover (4) and wherein with each socket contact (3) is associated a conductor unlatching mechanism (14) which is also disposed such that it is protected by the cover (4) when a conductor (15) is introduced into the socket contact (3), **characterized in that** the socket contacts (3) are disposed in a plug (5) with contact pins (6) and with the plug (5) is associated the cover (4), wherein one axial direction (7) of the socket contacts (3) and the contact pins (6) is implemented parallel and opposingly and wherein the contact pins (6) of the plug (5) are disposed in a division grid (10) and the cover (4) comprises slits (11) introduced on one side at the spacing of the division grid (10) such that cover lugs or flanges (12) are formed.

2. Field device as in claim 1, **characterized in that** the contact pins (6) of the plug (5) are plugged into sockets (8) that are molded into the field device (1).

3. Field device as in claim 1 or 2, **characterized in that** the cover (4) is secured on the field device (1) by means of threaded fasteners (9).

4. Field device as in one or several of the preceding claims, **characterized in that** several socket contacts (3) are implemented such that they are protected by a common cover (4).

5. Field device as in one or several of the preceding claims, **characterized in that** each cover lug or flange (12) comprises a predetermined breaking site (13).

6. Cover (4) for a field device as in claims 1 to 5, wherein the cover (4) for the placement onto the plug (5) comprises at least one guidance (16) in the direction of placement and transversely thereto a protective face (17) covering the socket contacts (3), wherein associated with each socket contact (3) is a conductor unlatching mechanism (14) which is disposed such that with a conductor (15) inserted into the socket contact (3) it is also covered by the cover (4), **characterized in that** the protective face (17) comprises slits (11) in the division grid (10) of the socket contacts (3) transversely to the edge (18) of the protective face (17) such that discrete cover lugs or flanges (12) are formed.

7. Cover (4) as in claim 6, **characterized in that** the guidance (16) is implemented as a wall (23) at least partially enveloping the plug (5) on three sides (20, 21, 22) and the protective face (17) extends only partially into the unenclosed zone (24).

8. Cover (4) as in claim 6 or 7, **characterized in that** the slits (11) are open toward the unenclosed zone (24) and extend only so far into the protective face (17) that the conductor unlatching mechanisms (14) of the plug (5) remain covered.

9. Cover (4) as in one of claims 6 to 8, **characterized in that** the cover lugs or flanges (12) are implemented at their ends (25) such that they are spaced apart from the plug (5).

10. Cover (4) as in one of claims 6 to 9, **characterized in that** the cover lugs or flanges (12) comprise predetermined breaking sites (13).

11. Cover (4) as in one of claims 6 to 10, **characterized in that** the cover lug or flange (12) comprises securement elements (26) for the securement on a field device (1).

12. Method for contacting or wiring non-intrinsically safe field devices as in one of claims 1 to 5, at heightened safety, wherein a plug (5) with contact pins (6) and socket contacts (3) is plugged into the field device with sockets (8) and the plug is covered by a cover (4) in the manner of a hood and the cover (4) is secured on the field device (1), wherein a protective face (17) comprises in the division grid (10) of the socket contacts (3) slits (11) transversely to the edge (18) of the protective face (17) such that discrete protective cover lugs or flanges (12) are formed, as well as the conductors (15) of the field devices, after removal of associated covering cover lugs or flanges (12), are plugged into the socket contacts (3) of the plug (5) and thereby are autonomously latched in the plug (5) or, instead of pluggable terminals, clamping blocks, fixedly connected with the field device, are employed, wherein a conductor unlatching mechanism (14) associated with each socket contact (3) also remains covered by the cover (4) when a conductor (15) is introduced into the socket contact (3).

## Revendications

1. Appareil de terrain comportant au moins une borne destinée à des appareils de terrain à sécurité non intrinsèque, par exemple des capteurs/actionneurs, et à être intégré dans un boîtier (2), dans lequel l'appareil de terrain comporte des douilles de contact (3) destinées au raccordement, qui sont réalisées sous la forme de contacts à serrage à auto-maintien chargés par ressort et déverrouillables ou sous la forme de bornes à vis normalisées de type Ex-e, dans lequel des douilles de contact (3) ou des bornes à vis non utilisées sont réalisées de manière protégée par un couvercle (4) et dans lequel, à chaque douille de contact est associé un déverrouillage de conducteur (14) qui est également agencé de manière à être recouvert par le couvercle (4) lors de l'insertion d'un conducteur (15) dans la douille de contact (3), **caractérisé en ce que** les douilles de contact (3) sont disposées dans un connecteur (5) ayant des broches de contact (6) et le couvercle (4) est associé au connecteur (5), dans lequel les directions axiales (7) des douilles de contact (3) et des broches de contact (6) sont réalisées de manière à être parallèles et opposées et dans lequel les broches de contact du connecteur (5) sont disposées dans une grille de division (10) et le couvercle (4) présente des fentes (11) ménagées d'un côté de manière espacée de la grille de division (10) afin de former des feuilles de recouvrement (12).

2. Appareil de terrain selon la revendication 1, **caractérisé en ce que** les broches de contact (6) du connecteur (5) sont insérées dans des douilles (8) qui sont noyées dans l'appareil de terrain (1).

3. Appareil de terrain selon la revendication 1 ou 2, **caractérisé en ce que** le couvercle (4) est fixé par des vis (9) à l'appareil de terrain (1).

4. Appareil de terrain selon l'une ou plusieurs des revendications précédentes, **caractérisé en ce qu'**une pluralité de douilles de contact (3) sont réalisées de manière protégée par un couvercle commun (4).

5. Appareil de terrain selon l'une ou plusieurs des revendications précédentes, **caractérisé en ce que** chaque feuille de recouvrement (12) comporte un point de rupture (13).

6. Couvercle (4) destiné à un appareil de terrain selon les revendications 1 à 5, dans lequel le couvercle (4) comporte au moins un guide (16) destiné à être emboité sur le connecteur (5) dans la direction d'insertion et comporte une surface de protection (17) recouvrant transversalement audit guide les douilles de contact (3), dans lequel, à chaque douille de contact (3) est associé un verrouillage de conducteur (14) qui est également recouvert par le couvercle (4) lors de l'insertion d'un conducteur (15) dans la douille de contact (3), **caractérisé en ce que** la surface de protection (17) comporte des fentes (11) dans la grille de division (10) des douilles de contact (3) transversalement au bord (18) de la surface de protection (17) de manière à former des feuilles de recouvrement de protection individuelles.

7. Couvercle selon la revendication 6, **caractérisé en ce que** le guide (16) est réalisé sous la forme d'une paroi (23) enveloppant au moins partiellement le connecteur (5) sur trois faces (20, 21, 22) et la surface de protection (17) ne pénètre que partiellement dans la surface dégagée (24).

8. Couvercle selon la revendication 6 ou 7, **caractérisé en ce que** les fentes (11) débouchent sur la surface dégagée (24) et pénètrent dans la surface de protection (17) de manière à ce que les déverrouillages de conducteurs (14) du connecteur (5) restent recouverts.

9. Couvercle selon l'une quelconque des revendications 6 à 8, **caractérisé en ce que** les feuilles de recouvrement (12) sont réalisées de manière espacée du connecteur (5) à leurs extrémités (25).

10. Couvercle selon l'une quelconque des revendications 6 à 9, **caractérisé en ce que** les feuilles de recouvrement (12) comportent des points de rupture (13).

11. Couvercle selon l'une quelconque des revendications 6 à 10, **caractérisé en ce que** le couvercle (12) comporte des éléments de fixation (26) servant à la fixation à un appareil de terrain (1).

12. Procédé de mise en contact ou de câblage de manière hautement sécurisée d'appareils de terrain à sécurité non intrinsèque selon l'une quelconque des revendications 1 à 5, dans lequel un connecteur (5) comportant des broches de contact (6) et des douilles de contact (3) est inséré dans l'appareil de terrain comportant des douilles (8) et le connecteur est recouvert d'un couvercle (4) à la façon d'un capot et le couvercle (4) est fixé à l'appareil de terrain (1), dans lequel une surface de protection (17) comporte des fentes (11) dans une grille de division (10) des douilles de contact (3), transversalement au bord (18) de la surface de protection (17), de manière à former des feuilles de recouvrement (12) individuelles de protection, et les conducteurs (15) de l'appareil de terrain sont insérés dans les douilles de contact (3) du connecteur (5) après avoir retiré les feuilles de recouvrement (12) de protection associées et sont de ce fait automatiquement verrouillés dans le connecteur (5) ou, au lieu de bornes enfichables, des borniers fermement reliés à l'appareil de terrain sont utilisés, dans lequel un déverrouillage de conducteur (14) associé à chacune des douilles de contact (3) reste également recouvert par le couvercle (4) lors de l'introduction d'un conducteur (15) dans la douille de contact (3).
